# EUROPÄISCHE PATENTANMELDUNG

(11) **EP 4 610 976 A1**
(43) Veröffentlichungstag der Anmeldung: **03.09.2025**
(21) Anmeldenummer: 24160482.6
(22) Anmeldetag: 29.02.2024
(51) Int. Cl.: G10K 11/178, H05K 7/20, A47B 81/00

(54) **SCHRANK FÜR EIN ODER MEHRERE GERÄUSCHE\KÖRPERSCHALL-EMITTIERENDE TECHNISCHE GERÄTE, VERFAHREN**

(71) Anmelder: Siemens Aktiengesellschaft, 80333 München (DE)
(72) Erfinder: Ochs, Ewgenij, 90617 Puschendorf (DE); Kiesel, Alexander, 82467 Garmisch-Partenkirchen (DE); Kneißl, Philipp, 90427 Nürnberg (DE); Schwarz, Florian, 90766 Fürth (DE)
(74) Vertreter: Siemens Patent Attorneys

(57) **Zusammenfassung**

Die Erfindung betrifft einen Schrank für ein oder mehrere Geräusche\Körperschall (NSE) emittierende technische Geräte (UNT), die in dem Schrank (RCK) betrieben werden, insbesondere Schaltschrank, Serverschrank, Umrichterschrank, Frequenzumrichterschrank, Rackschrank oder Steuerschrank. Es wird vorgeschlagen, der Schrank (RCK) eine aktive Geräusch\Körperschall-Unterdrückungsvorrichtung (NSP) zumindest teilweise als Bestandteil des Schranks (RCK) umfasst, die die Geräusch\Körperschall-Emission (EMS) des Schranks (RCK) reduziert, die durch den Betrieb der in dem Schrank (RCK) befindlichen Geräte (UNT) verursacht ist.

## Beschreibung

Die Erfindung betrifft einen Schrank für ein oder mehrere Geräusche\Körperschall-emittierende technische Geräte, gemäß dem Oberbegriff von Anspruch 1 sowie ein Verfahren zur Geräusch\Körperschall-Unterdrückung an einem Schrank für ein oder mehrere technische Geräte, die in dem Schrank betrieben werden, gemäß dem leitenden Verfahrensanspruch.

Der bekannte Stand der Technik von dem die Erfindung ausgeht, betrifft einen Schrank gemäß dem Oberbegriff von Anspruch 1.

Es ist dabei eine Herausforderung, den bekannten Stand der Technik zu verbessern.

Der Erfindung liegt das Problem zugrunde, den bekannten Schrank derart auszugestalten und weiterzubilden, dass hinsichtlich der genannten Herausforderung eine weitere Optimierung erreicht wird.

Das obige Problem wird durch die Merkmale des kennzeichnenden Teils von Anspruch 1 gelöst.

Wesentlich ist die grundsätzliche Überlegung, die Geräusche\Körperschall-nicht nur passiv zu unterdrücken, sondern auch aktiv.

Im Einzelnen wird vorgeschlagen, dass der Schrank eine aktive Geräusch\Körperschall-Unterdrückungsvorrichtung zumindest teilweise als Bestandteil des Schranks umfasst, die die Geräusch\Körperschall-Emission des Schranks reduziert, die durch den Betrieb der in dem Schrank befindlichen Geräte verursacht ist.

Der in diesem Dokument verwendete Ausdruck "Geräusch\Körperschall" und dessen Abwandlungen bedeuten ausdrücklich eine Zusammenfassung von einerseits gleichzeitigem Auftreten von Geräusch und Körperschall sowie anderseits das Auftreten von Geräusch oder Körperschall (beispielsweise im Vakuum) in jeweiliger Alleinstellung oder bei einer stark unterschiedlichen Ausprägung dieser beiden Phänomene. Üblicherweise würde dieser Umstand in patentbezogenen Schriften mit "Geräusch und/oder Körperschall" ausgedrückt werden. Dieser Ausdruck ist zugunsten der besseren Lesbarkeit vorliegend verkürzt worden auf "Geräusch\Körperschall".

Geräusche und Geräuschemissionen beziehen sich auf den Klang oder die Schallwellen, die durch eine Schallquelle erzeugt und in der Luft oder einem anderen Medium ausgebreitet werden. Sie werden normalerweise als hörbare Schallwellen wahrgenommen und können von verschiedenen Quellen beispielsweise von Maschinen erzeugt werden.

Mechanische Schwingungen oder Körperschall beziehen sich auf die Vibrationen oder Bewegungen eines physischen Körpers, die sich auf andere Objekte oder Strukturen übertragen können. Diese Schwingungen können sowohl hörbar als auch nicht hörbar sein.

Der Hauptunterschied zwischen Geräuschen und mechanischen Schwingungen besteht darin, dass Geräusche Schallwellen in der Luft oder einem Medium sind, während mechanische Schwingungen die physische Bewegung oder Vibration eines Körpers darstellen.

Die Unterscheidung zwischen Körperschall und mechanische Schwingungen liegt darin, dass mechanische Schwingungen die Bewegung des schwingenden Körpers selbst beschreiben, während Körperschall die Übertragung dieser Schwingungen auf andere Objekte oder Strukturen beschreibt.

Vorteilhafte Ausgestaltungen der Erfindung beziehen sich auf eine Ausbildung des Schrankes als Serverschrank. Hierbei ist ein Serverschrank ist ein spezieller Schrank, der für die Aufbewahrung von Servern, Netzwerkkomponenten und anderen IT-Geräten vorgesehen ist. Er bietet Platz für die Montage von Servern, Switches, Patch-Panels, Kabelmanagement und Kühlungseinheiten, um eine ordnungsgemäße Funktion und Sicherheit der Geräte zu gewährleisten.

Eine andere Möglichkeit ist gegeben durch eine Ausbildung als Patch-Schrank oder Patchpanel-Schrank. Hierbei handelt es sich um einen Schrank, der speziell für die Aufbewahrung von Patch-Panels, Netzwerk-Switches und Verkabelungskomponenten vorgesehen ist. Er ermöglicht eine organisierte Verkabelung und erleichtert das Patchen von Netzwerkverbindungen.

Eine weitere vorteilhafte Möglichkeit ist gegeben durch eine Ausbildung als Rackschrank. Ein Rackschrank ist ein Schrank, der für die Montage von elektronischen Geräten in standardisierten Racks vorgesehen ist. Er wird häufig in Rechenzentren, Telekommunikationsanlagen und anderen technischen Umgebungen eingesetzt, um Geräte wie Server, Switches, Router, Audio- und Videogeräte usw. zu montieren und zu schützen.

Eine weitere vorteilhafte Möglichkeit ist gegeben durch eine Ausbildung als Steuerschrank: Ein Steuerschrank oder Schaltschrank für Steuerungstechnik ist ein Schrank, der für die Montage von Steuerungskomponenten wie Schalttafeln, Schaltplänen, Steuerungssystemen, Relais und Schützen vorgesehen ist. Er wird in industriellen Anlagen, Gebäuden oder Maschinen eingesetzt, um die Steuerung und Überwachung von Prozessen zu ermöglichen.

Eine weitere vorteilhafte Möglichkeit ist gegeben durch eine Ausbildung als ein Schrank für Umrichter, der als Umrichterschrank oder Frequenzumrichterschrank bezeichnet werden. Ein Umrichter ist ein elektronisches Gerät, das die Frequenz und Spannung einer elektrischen Energiequelle ändert, um die Geschwindigkeit von Elektromotoren zu steuern.

Nach einer weiteren Lehre gemäß Anspruch 14, der eine eigenständige Bedeutung, zukommt, wird ein Verfahren zur Geräusch\Körperschall-Unterdrückung an einem Schrank für ein oder mehrere technische Geräte, die in dem Schrank betrieben werden, insbesondere für einen Schrank nach einem der vorhergehenden Ansprüche, gekennzeichnet dadurch, dass das Verfahren eine aktive Geräusch\Körperschall-Unterdrückung zumindest teilweise als Bestandteil des Schranks vorsieht.

Auf alle Ausführungen zu dem vorschlagsgemäßen Schrank wird bezüglich des Verfahrens an dieser Stelle verwiesen.

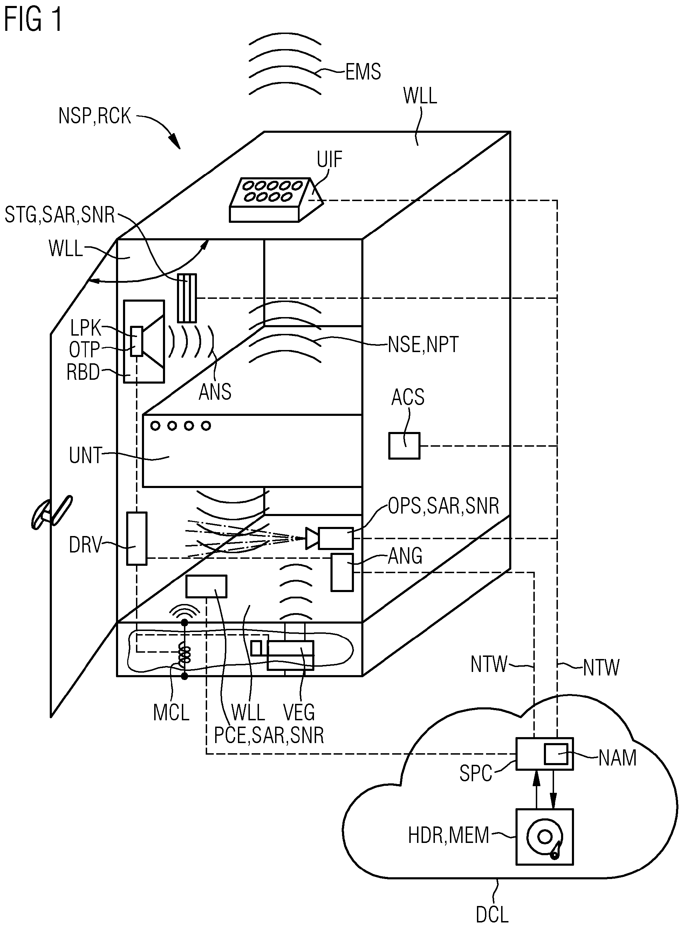

Im Folgenden wird die Erfindung anhand einer lediglich Ausführungsbeispiele darstellenden Zeichnung näher erläutert. Es zeigt
- Figur 1:: eine vereinfachte schematische Darstellung eines erfindungsgemäßen Schrankes zur Durchführung des erfindungsgemäßen Verfahrens.

Das in der Figur dargestellte und insoweit bevorzugte Ausführungsbeispiel betrifft einen Schrank RCK für ein oder mehrere Geräusche\Körperschall-NSE emittierende technische Geräte UNT, die in dem Schrank RCK betrieben werden, insbesondere Schaltschrank, Serverschrank, Umrichterschrank, Frequenzumrichterschrank, Rackschrank oder Steuerschrank.

Der Schrank RCK umfasst eine aktive Geräusch\Körperschall-Unterdrückungsvorrichtung NSP zumindest teilweise als Bestandteil des Schranks RCK, die die Geräusch\Körperschall-Emission EMS des Schranks RCK reduziert, die durch den Betrieb der in dem Schrank RCK befindlichen Geräte UNT verursacht ist.

Weiter ist vorgesehen, dass die Geräusch\Körperschall-Unterdrückungsvorrichtung NSP umfasst:
a) mindestens einen Sensor SNR oder ein Sensorarray SAR, das zur Erfassung von Geräuschen\Körperschall NSE konfiguriert ist;
b) einen Signalprozessor SPC in Kommunikation mit dem Sensor SNR oder Sensorarray SAR, wobei der Signalprozessor SPC konfiguriert ist, um die erfassten Geräusche\Körperschall NSE zu empfangen und zu verarbeiten;
c) einen Anti-Geräusch\Körperschall-Generator ANG in Kommunikation mit dem Signalprozessor SPC, wobei der Anti-Geräusch\Körperschall-Generator ANG konfiguriert ist, um Anti-Geräusch\Körperschall-Signale ANS basierend auf den verarbeiteten Geräuschen\Körperschall NSE zu erzeugen;
d) einen Treiber DRV, der mit dem Anti-Geräusch\Körperschall-Generator ANG in Verbindung steht, wobei der Treiber DRV konfiguriert ist, um Signale SGN zu erzeugen, die die Anti-Geräusch\Körperschall-Signale ANS umfassen; und
e) eine Ausgabevorrichtung OTP in Kommunikation mit dem Treiber DRV, wobei die Ausgabevorrichtung OTP konfiguriert ist, um die Signale SGN auszugeben.

Der Signalprozessor SPC kann als direkter Bestandteil des Schrankes ausgebildet sein oder als entfernter Bestandteil, wie hier symbolhaft als Bestandteil einer Datencloud. Der Signalprozessor SPC kann mit einem Datenspeicher MEM - hier als Festplatte symbolisiert HDR - in Verbindung stehen. Dort kann gegebenenfalls ein Zugriff auf eine Datenbank erfolgen, in der ähnliche Geräusch\Körperschall-Unterdrückungsprobleme bereits mit Lösungsparametern für die Verarbeitung der Geräusche\Körperschall-NSE hinterlegt sind, um Anti-Geräusch\Körperschall-Signale ANS basierend auf den verarbeiteten Geräuschen\Körperschall NSE zu erzeugen.

Der Treiber DRV, der Anti-Geräusch\Körperschall-Generator ANG und die Ausgabevorrichtung OTP sind Bestandteile der Geräusch\Körperschall-Unterdrückungsvorrichtung NSP und haben unterschiedliche Funktionen, wie folgend erläutert ist.

Der Treiber DRV ist dafür vorgesehen, Signale SGN zu erzeugen, die die Anti-Geräusch\Körperschall-Signale ANS umfassen. Der Treiber DRV kann als Verstärker oder eine ähnliche Komponente ausgebildet sein, die die erzeugten Anti-Geräusch\Körperschall-Signale ANS verstärkt und für die weitere Verarbeitung bereitstellt.

Der Anti-Geräusch\Körperschall-Generator ANG erzeugt die Anti-Geräusch\Körperschall-Signale ANS basierend auf den verarbeiteten Geräuschen\Körperschall NSE. Dieser Generator nutzt Algorithmen oder Prozesse, um die erfassten Geräusche\Körperschall-NSE zu analysieren und passende Anti-Geräusch\Körperschall-Signale ANS zu erzeugen. Diese Anti-Geräusch\Körperschall-Signale ANS werden dann verwendet, um das ursprüngliche Geräusch\Körperschall NSE zu kompensieren oder zu eliminieren - zumindest durch Überlagerung zu reduzieren.

Die Ausgabevorrichtung OTP ist dafür vorgesehen, die Signale SGN auszugeben. Es handelt sich hierbei um einen Lautsprecher LPK oder eine ähnliche Komponente, die die verarbeiteten Signale SGN wiedergibt. Die Ausgabevorrichtung OTP ermöglicht es dem Benutzer, das Ergebnis der Geräusch\Körperschall-Unterdrückung NRD zu hören oder anderweitig wahrzunehmen.

Zusammenfassend kann man sagen, dass der Treiber DRV die Anti-Geräusch\Körperschall-Signale ANS erzeugt, der Anti-Geräusch\Körperschall-Generator ANG die Anti-Geräusch\Körperschall-Signale ANS generiert und die Ausgabevorrichtung OTP die verarbeiteten Signale SGN ausgibt.

Weiter ist hier und vorzugsweise vorgesehen, dass das Sensorarray SAR mehrere Sensoren SNR umfasst, die in einer räumlichen Konfiguration angeordnet sind, um die Geräusche\Körperschall-NSE aus verschiedenen Richtungen zu erfassen.

Weiter ist hier und vorzugsweise vorgesehen, dass der Signalprozessor SPC ferner ein Geräusch\Körperschall-Analysemodul NAM umfasst, das konfiguriert ist, um die erfassten Geräusche\Körperschall-NSE zu analysieren und spezifische Geräusch\Körperschall-Frequenzen NSE oder Geräusch\Körperschall-Muster NPT zu identifizieren.

Weiter ist hier und vorzugsweise vorgesehen, der Anti-Geräusch\Körperschall-Generator ANG ferner konfiguriert ist, um die Intensität oder Phase der erzeugten Anti-Geräusch\Körperschall-Signale ANS basierend auf den Eigenschaften der erfassten Geräusche\Körperschall-NSE einzustellen.

Weiter ist hier und vorzugsweise vorgesehen, die Ausgabevorrichtung OTP in oder an dem Schrank RCK angebracht ist und mindestens einen Lautsprecher LPK und/oder einen Vibrationsmotor VEG und/oder eine Schwingspule MCL und/oder ein Piezoelement PCE umfasst.

Weiter ist hier und vorzugsweise vorgesehen, der Sensor SNR oder das Sensorarray SAR mindestens ein Mikrofon MCP und/oder einen optischen Sensor OPS und/oder einen Beschleunigungssensor ACS und/oder einen Dehnmessstreifen STG umfasst.

Weiter ist hier und vorzugsweise vorgesehen, Signalprozessor SPC als Bestandteil des Schranks RCK ausgebildet ist.

Weiter ist hier und vorzugsweise vorgesehen, der Signalprozessor SPC als Bestandteil eines mit dem Schrank RCK in Signale SGN übertragender Verbindung stehendem Netzwerk NTW, insbesondere als Bestandteil einer Datencloud DCL, ausgebildet ist. Das Netzwerk kann hierbei zumindest teilweise kabelgebunden und/oder kabellos ausgebildet sein.

Weiter ist hier und vorzugsweise vorgesehen, der Schrank RCK eine Benutzerschnittstelle UIF umfasst, die so konfiguriert ist, dass sie es einem Benutzer ermöglicht, den Grad der Geräusch\Körperschall-Unterdrückung NRD einzustellen oder verschiedene Geräusch\Körperschall-Unterdrückungsmodi NSM auszuwählen.

Weiter ist hier und vorzugsweise vorgesehen, die Ausgabevorrichtung OTP an einer Wandung WLL des Schranks RCK angebracht ist, insbesondere an einer Rückwand und/oder an der Bodenplatte und/oder einer Oberseite und/oder an einer Seitenwand und/oder an einer Frontwand.

Weiter ist hier und vorzugsweise vorgesehen, der Schrank RCK einen zusätzlichen Resonanzkörper RBD aufweist, der derart ausgebildet ist und mit der Ausgabevorrichtung OTP verbunden ist, dass von der Ausgabevorrichtung OTP erzeugte Schwingungen von dem Resonanzkörper RBD verstärkt werden.

Weiter ist hier und vorzugsweise vorgesehen, die Ausgabevorrichtung OTP zwischen dem oder den Geräusche\Körperschall-NSE emittierende(n) technischen Geräte(n) UNT und einer Wandung WLL, insbesondere einer Rückwand und/oder der Bodenplatte und/oder einer Oberseite und/oder an einer Seitenwand und/oder an einer Frontwand, angeordnet ist.

Vorgeschlagen wird gemäß einer weiteren Lehre ein Verfahren zur Geräusch\Körperschall-Unterdrückung NRD an einem Schrank RCK für ein oder mehrere technische Geräte UNT, die in dem Schrank RCK betrieben werden, insbesondere für einen Schrank RCK nach einem der vorhergehenden Ansprüche, gekennzeichnet dadurch, dass das Verfahren eine aktive Geräusch\Körperschall-Unterdrückung NRD zumindest teilweise als Bestandteil des Schranks RCK vorsieht.

Auf alle Ausführungsvorschläge zu dem erfindungsgemäßen Schrank RCK sind auch für das erfindungsgemäße Verfahren relevant.

Weiter ist hier und vorzugsweise vorgesehen, die aktive Geräusch\Körperschall-Unterdrückung NRD umfasst:
a) Aufnahme von Geräuschen\Körperschall NSE mit einem Sensor SNR oder Sensorarray SAR;
b) Verarbeitung der aufgenommenen Geräusche\Körperschall-NSE unter Verwendung eines Signalprozessors SPC;
c) Erzeugen von Anti-Geräusch\Körperschall-Signalen ANS auf der Grundlage der verarbeiteten Geräusche\Körperschall-NSE unter Verwendung eines Anti-Geräusch\Körperschall-Generators ANG;
d) Erzeugen von Signalen SGN, die die Anti-Geräusch\Körperschall-Signale ANS unter Verwendung eines Audiotreibers umfassen; und
e) Ausgabe der Signale SGN mittels eines Ausgabegeräts.

Unabhängig vom grammatikalischen Geschlecht eines bestimmten Begriffes sind Personen mit männlicher, weiblicher oder anderer Geschlechteridentität mit umfasst.

## Patentansprüche

1. Schrank für ein oder mehrere Geräusche\Körperschall (NSE) emittierende technische Geräte (UNT), die in dem Schrank (RCK) betrieben werden, insbesondere Schaltschrank, Serverschrank, Umrichterschrank, Frequenzumrichterschrank, Rackschrank oder Steuerschrank, **dadurch gekennzeichnet, dass** der Schrank (RCK) eine aktive Geräusch\Körperschall-Unterdrückungsvorrichtung (NSP) zumindest teilweise als Bestandteil des Schranks (RCK) an dem Schrank angebracht ist, die die Geräusch\Körperschall-Emission (EMS) des Schranks (RCK) reduziert, die durch den Betrieb der in dem Schrank (RCK) befindlichen Geräte (UNT) verursacht ist.

2. Schrank nach Anspruch 1, wobei die Geräusch\Körperschall-Unterdrückungsvorrichtung (NSP) umfasst:
a) mindestens einen Sensor (SNR) oder ein Sensorarray (SAR), das zur Erfassung von Geräuschen\Körperschall (NSE) konfiguriert ist;
b) einen Signalprozessor (SPC) in Kommunikation mit dem Sensor (SNR) oder Sensorarray (SAR), wobei der Signalprozessor (SPC) konfiguriert ist, um die erfassten Geräusche\Körperschall (NSE) zu empfangen und zu verarbeiten;
c) einen Anti-Geräusch\Körperschall-Generator (ANG) in Kommunikation mit dem Signalprozessor (SPC), wobei der Anti-Geräusch\Körperschall-Generator (ANG) konfiguriert ist, um Anti-Geräusch\Körperschall-Signale (ANS) basierend auf den verarbeiteten Geräuschen\Körperschall (NSE) zu erzeugen;
d) einen Treiber (DRV), der mit dem Anti-Geräusch\Körperschall-Generator (ANG) in Verbindung steht, wobei der Treiber (DRV) konfiguriert ist, um Signale (SGN) zu erzeugen, die die Anti-Geräusch\Körperschall-Signale (ANS) umfassen; und
e) eine Ausgabevorrichtung (OTP) in Kommunikation mit dem Treiber (DRV), wobei die Ausgabevorrichtung (OTP) konfiguriert ist, um die Signale (SGN) auszugeben.

3. Schrank nach Anspruch 1 oder 2, wobei das Sensorarray (SAR) mehrere Sensoren (SNR) umfasst, die in einer räumlichen Konfiguration angeordnet sind, um die Geräusche\Körperschall (NSE) aus verschiedenen Richtungen zu erfassen.

4. Schrank nach einem der vorhergehenden Ansprüche, wobei der Signalprozessor (SPC) ferner ein Geräusch\Körperschall-Analysemodul (NAM) umfasst, das konfiguriert ist, um die erfassten Geräusche\Körperschall (NSE) zu analysieren und spezifische Geräusch\Körperschall-Frequenzen (NSE) oder Geräusch\Körperschall-Muster (NPT) zu identifizieren.

5. Schrank nach einem der vorhergehenden Ansprüche, wobei der Anti-Geräusch\Körperschall-Generator (ANG) ferner konfiguriert ist, um die Intensität oder Phase der erzeugten Anti-Geräusch\Körperschall-Signale (ANS) basierend auf den Eigenschaften der erfassten Geräusche\Körperschall (NSE) einzustellen.

6. Schrank nach einem der vorhergehenden Ansprüche, wobei die Ausgabevorrichtung (OTP) in oder an dem Schrank (RCK) angebracht ist und mindestens einen Lautsprecher (LPK) und/oder einen Vibrationsmotor (VEG) und/oder eine Schwingspule (MCL) und/oder ein Piezoelement (PCE) umfasst.

7. Schrank nach einem der vorhergehenden Ansprüche, wobei der Sensor (SNR) oder das Sensorarray (SAR) mindestens ein Mikrofon (MCP) und/oder einen optischen Sensor (OPS) und/oder einen Beschleunigungssensor (ACS) und/oder einen Dehnmessstreifen (STG) umfasst.

8. Schrank nach mindestens dem vorhergehenden Anspruch 2, wobei der Signalprozessor (SPC) als Bestandteil des Schranks (RCK) ausgebildet ist.

9. Schrank nach einem der vorhergehenden Ansprüche, wobei der Signalprozessor (SPC) als Bestandteil eines mit dem Schrank (RCK) in Signale (SGN) übertragender Verbindung stehendem Netzwerk (NTW), insbesondere als Bestandteil einer Datencloud (DCL), ausgebildet ist.

10. Schrank nach einem der vorhergehenden Ansprüche, wobei der Schrank (RCK) eine Benutzerschnittstelle (UIF) umfasst, die so konfiguriert ist, dass sie es einem Benutzer ermöglicht, den Grad der Geräusch\Körperschall-Unterdrückung (NRD) einzustellen oder verschiedene Geräusch\Körperschall-Unterdrückungsmodi (NSM) auszuwählen.

11. Schrank nach einem der vorhergehenden Ansprüche, wobei die Ausgabevorrichtung (OTP) an einer Wandung (WLL) des Schranks (RCK) angebracht ist, insbesondere an einer Rückwand und/oder an der Bodenplatte und/oder einer Oberseite und/oder an einer Seitenwand und/oder an einer Frontwand.

12. Schrank nach einem der vorhergehenden Ansprüche, wobei der Schrank (RCK) einen zusätzlichen Resonanzkörper (RBD) aufweist, der derart ausgebildet ist und mit der Ausgabevorrichtung (OTP) verbunden ist, dass von der Ausgabevorrichtung (OTP) erzeugte Schwingungen von dem Resonanzkörper (RBD) verstärkt werden.

13. Schrank nach einem der vorhergehenden Ansprüche, wobei die Ausgabevorrichtung (OTP) zwischen dem oder den Geräusche\Körperschall (NSE) emittierende(n) technischen Geräte(n) (UNT) und einer Wandung (WLL), insbesondere einer Rückwand und/oder der Bodenplatte und/oder einer Oberseite und/oder an einer Seitenwand und/oder an einer Frontwand, angeordnet ist.

14. Verfahren zur Geräusch\Körperschall-Unterdrückung (NRD) an einem Schrank (RCK) für ein oder mehrere technische Geräte (UNT), die in dem Schrank (RCK) betrieben werden, insbesondere für einen Schrank (RCK) nach einem der vorhergehenden Ansprüche, **gekennzeichnet dadurch, dass** das Verfahren eine aktive Geräusch\Körperschall-Unterdrückung (NRD) zumindest teilweise als Bestandteil des Schranks (RCK) vorsieht.

15. Verfahren nach Anspruch 8 oder 9, wobei die aktive Geräusch\Körperschall-Unterdrückung (NRD) umfasst:
a) Aufnahme von Geräuschen\Körperschall (NSE) mit einem Sensor (SNR) oder Sensorarray (SAR);
b) Verarbeitung der aufgenommenen Geräusche\Körperschall (NSE) unter Verwendung eines Signalprozessors (SPC);
c) Erzeugen von Anti-Geräusch\Körperschall-Signalen (ANS) auf der Grundlage der verarbeiteten Geräusche\Körperschall (NSE) unter Verwendung eines Anti-Geräusch\Körperschall-Generators (ANG);
d) Erzeugen von Signalen (SGN), die die Anti-Geräusch\Körperschall-Signale (ANS) unter Verwendung eines Audiotreibers umfassen; und
e) Ausgabe der Signale (SGN) mittels eines Ausgabegeräts.
